# EUROPEAN PATENT APPLICATION

(11) **EP 1 641 035 A1**
(43) Date of publication of application: **29.03.2006**
(21) Application number: 04425716.0
(22) Date of filing: 27.09.2004
(51) Int. Cl.: H01L 21/60

(54) **Mounting method of electronic power components on printed circuit boards**

(71) Applicant: STMicroelectronics S.r.l., 20041 Agrate Brianza (Milano) (IT)
(72) Inventor: Minotti, Agatino, 95030 Mascalucia (Catania) (IT)
(74) Representative: Botti, Mario

(57) **Abstract**

The present invention relates to a mounting method, on printed circuit boards, electronic components integrated on semiconductor dies wherein an insulating and protecting layer is provided between die and board with passage openings of electric contacts which allow the welding of contact pads of the die with ends of the printed circuit board.

## Description

### Field of application

The present invention relates to a mounting method of power and/or signal electronic components to be assembled on printed circuit boards PCB with pads or conducting tracks.

More specifically the invention relates to a mounting method wherein each component comprises a die of semiconductor material whereon an integrated circuit has been realised with pads or electric contact ends.

The invention particularly, but not exclusively, relates to a mounting method of power and signal electronic components assembled on printed circuit boards and the following description is made with reference to this field of application, for convenience of illustration only.

As it is well known, a monolithically integrated electronic component normally comprises a die of semiconductor material, so called "die", of a few squared millimetres of surface, whereon an electronic circuit and a package casing has been integrated wrapping the circuit and typically realised by molding of plastic material.

The package obviously allows to ensure a suitable mechanical and thermal protection to the die of semiconductor material.

The die of semiconductor material, which integrates the electronic circuit, leans on a conductor protection element made of a thin treated metallic plate called "lead frame".

The most used electronic components have some output connectors or leads and for this reason they are said leaded electronic components.

In the leaded components, the die of semiconductor material is equipped with a plurality of contact ends or pads, peripherally formed and electrically interconnected with a corresponding connector of the lead frame.

Therefore, the connectors of the lead frame have an internal end electrically connected with a contact pad of the die and an opposite free end which results to be protruded outside the package to form the so called electrical interconnection pins of the electronic component.

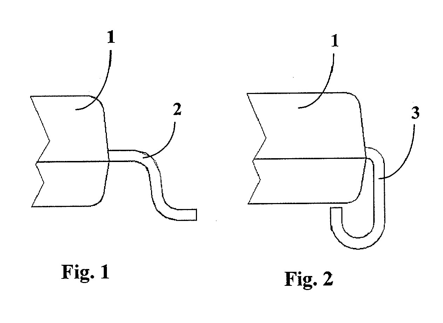

In figures 1 and 2 the most common types of pins for leaded components are shown.

In particular, in figure 1, a side, partial view is shown of an electronic components wherefrom a standard pin departs with a gull wing bending.

In figure 2, a side, partial view is instead shown of an electronic component wherefrom a standard pin departs with a "J" bending.

As it is well known, there exist several mounting technologies of electronic components on plane surfaces such as, for example, printed circuit boards PCB.

A first technology, being already used in the past still nowadays, is known as "through holes" and it allows the mounting of electronic components through the realisation of holes on the surface of (PCB).

A second technology, being already used in the past still nowadays, is that of mounting on surface (Surface Mounting Technology SMT); unfortunately, also this one suffers from important limitations which can be led to the unperfect complanarity of the different layers and of the different components making the electric component.

### Prior art

The continuous reduction of the electronic circuit dimensions, with the subsequent need of reducing also the dimensions of the electronic components containing them, has also induced the mounting technologies and, in particular the SMT technology, to evolve consequently.

The always greater miniaturization of the electronic circuits require that the electronic components and the relative packages are more and more reduced in dimension and thickness up to come to a ratio between the die of semiconductor material and the package of 1:1. This is exactly the case of the packages with CHIP dimension (Chip Scale Package CSP).

The mounting technologies of these chip packages, are called CSP or mounting technologies on reduced surfaces or Small SMT (Small Surface Mounting Packages).

At this point the tie on the dimensions and on the distances between the leaded components and the contact points or contact pads in the unleaded components becomes more and more stringent.

The distances between leads, pads or contact points, which hereafter in the description will be globally indicated with the denomination of "contact centres", must be lower of some micron centinaio with respect to those relative to the standard mounting technologies "Through Holes" or to the so far known mounting technologies on surface SMT.

The new Small SMT and CSP technologies are also determining some changes in the configuration of the "leads" of the electronic components allowing the use of different approaches which allow the maximisation of the ratio between the dimensions of the semiconductor die and of the package by using an area placed more outside the packages themselves.

These approaches use electronic components devoid of output connectors and commonly called unleaded electronic components.

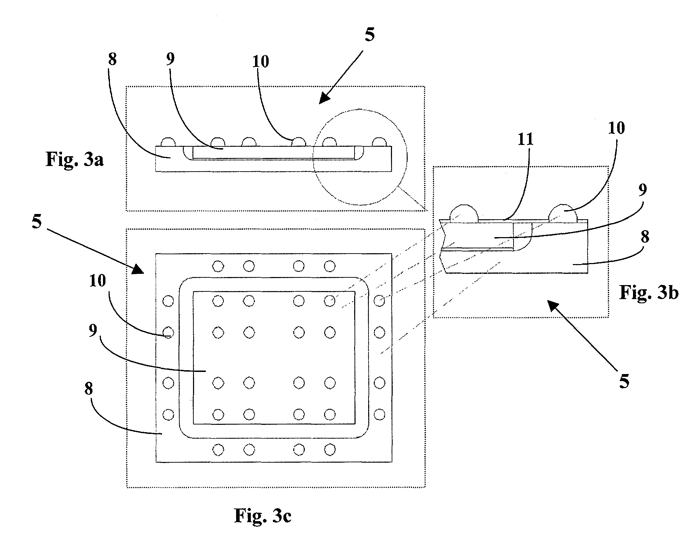

In particular figures 3a, 3b and 3c show respective views: in section, an enlarged detail of the section view and a plan view of a first electronic component 5 of the unleaded type.

This component 5 comprises an external lid layer 8, essentially tray-like shaped, wherein the die 9 of semiconductor material incorporating the integrated electronic device is located.

The supporting layer 8 superficially has on its own edges, a plurality of contact points 10, called solder balls which are present, in turn, also on the die 9 of semiconductor material.

This type of electronic component is directly glued to a printed circuit board PCB by means of resin placed on the rear of the supporting layer 8.

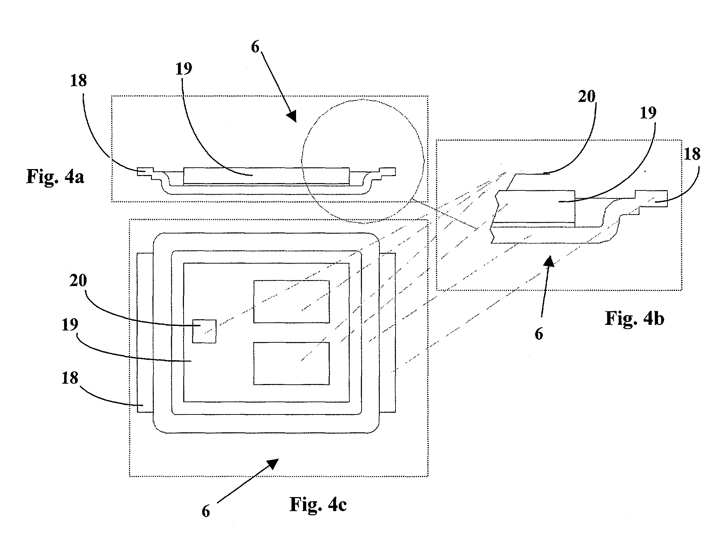

Figures 4a, 4b and 4c show respective views: in section, an enlarged detail of the section view and a plan view of a second electronic component 6 of the unleaded type.

Also this second electronic component comprises an external supporting layer 18 whereon a die 19 of semiconductor material is placed.

The supporting layer 18 has on peripheral edges a plurality of input/output contact pads 20 which are also present on the die 19. The contact pads 20 are electrically interconnected to the supporting layer 18.

Unfortunately, although the CSP and Small SMT mounting technologies have brought evident improvements and updates to the standard "trough holes" techniques or to the old SMT technologies, also have remarkable problems.

Both the old mounting technologies for leaded electronic components and the most recent technologies for unleaded components do no in fact succeed in ensuring a perfect arrangement and a perfect coplanarity of the contact centres during the assembly thereof on the printed circuit boards (PCB).

As regards the mounting technologies for leaded electronic components, the unperfect arrangement or the unperfect coplanarity of the contact centres can be due to different reasons such as misalignments between the leads on the board, deformations of the components caused by false or wrong contacts during the testing, non suitable manipulations or crashes.

As regards the mounting technologies for unleaded electronic components, the unperfect arrangement or the unperfect coplanarity of the contact centres can be mainly due to a wrong combination if thickness tolerances of the different layers making the electronic component.

In particular, in the mounting technologies for leaded electronic components, the wrong assembly can imply a crumbling of the protection package and a repairing step is necessary with reconditioning.

On the contrary, in the mounting technologies for unleaded electronic components the wrong assembly implies the non usability of the electronic component in its entirety.

It is worth citing another SMT technology which uses welding small solder bumps o solder pads which are formed by solder deposition between two surfaces to be welded with each other, those surfaces being usually the printed circuit board PCB and the die of semiconductor material of the electronic component.

The die is prone placed on the printed circuit board so that the two facing surfaces are welded together through a solder reflow which invests the respective welding small balls or the pads.

This however implies mechanical stresses on the die of semiconductor material during the thermal expansion and contraction steps of the printed circuit board since between the board and the die there are only thin layers of welding small balls (about 100-300 micron) or of welding pads (about 25-70 micron).

In addition, since the die remains uncovered and prone placed on the printed circuit board, it is subjected to damages due to the bad environmental conditions, or to residual current streams or to the presence of particles of undesired material.

In most cases, for overcoming these problems, an expensive filling operation is necessary below the die of semiconductor material; this operation provides for example an injection of coating gel or of a suitable resin between the frontal part of the die of semiconductor material and the printed circuit board.

The technical problem underlying the present invention is that of devising a new mounting method for electronic components, having such functional characteristics as to allow suitable coplanarity and arrangement of the contact centres ensuring in the meantime a suitable protection of the die of semiconductor material in case of mechanical stresses induced by the printed circuit boards or by environmental operative bad conditions, or even in case particle of undesired material are present on the package or on the printed circuit board.

This method should allow to overcome the limits and/or drawbacks of the previous solutions shown with reference to the prior art.

### Summary of the invention

The solution idea on which the present invention is based is very simple and provides for the interposition of a suitable shock-absorber layer between the die of semiconductor material and the printed circuit board, such a layer being able to avoid that the silicon is subjected to mechanical stresses during the thermal expansion and contraction steps of the printed circuit board or to damages due to the bad environmental operative conditions, or to residual current streams or to the presence of particles of undesired material.

On the basis of this solution idea the technical problem underlying the present invention is solved by a mounting method for electronic components as previously indicated and defined by the characterising part of claim 1.

The characteristics and advantages of the method according to the invention will be apparent from the following description of an embodiment thereof given by way of indicative and non-limiting example with reference to the annexed drawings.

### Brief description of the drawings

In these drawings:
figure 1 shows a partial side view of an electronic component of the leaded type with pins called gull wing-like, according to the prior art;
figure 2 shows a partial side view of a leaded electronic component with "J"-like pins, according to the prior art;
figures 3a, 3b and 3c schematically show respective views of a first type of unleaded electronic component, according to the prior art;
figures 4a, 4b and 4c schematically show respective views of a second type of unleaded electronic component, according to the prior art;
figures 5a, 5b, 5c and 5d show respective schematic views of an unleaded electronic component realised according to the (thin) method of the present invention;
figures 6a, 6b, 6c and 6d show respective schematic views of an unleaded electronic component realised according to a second (thick) embodiment of the method according to the invention.

### Detailed description

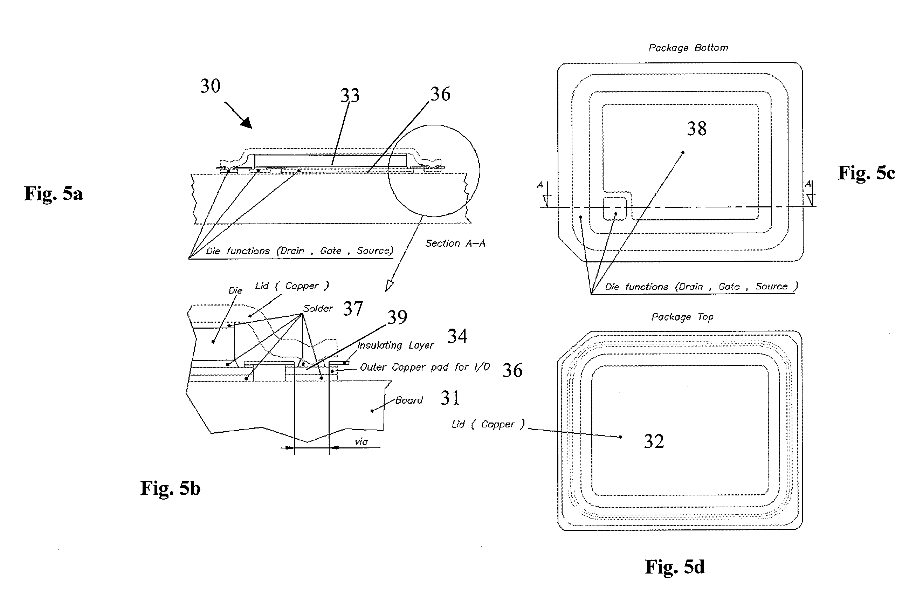

With reference to these figures, and in particular to the examples of figures 5a, 5b and 5c, 30 schematically show an unleaded electronic component 30 realised according to the present invention and floating or leaning on a printed circuit board PCB 31 according to an approach which will be hereafter defined of the "thin" type.

Figures 5a and 5b show respective side views of the component 30; whereas figures 5c and 5d show respective top and bottom views of said component 30.

The component 30 comprises a protection lid element 32 or cover of conductive material, for example copper, substantially tray-like shaped and associated with the board 31 in a reversed tray-like shape with peripheral edges which lean on the board and maintain the tray plane parallel to the board 31 and in a prefixed spaced relation.

A flat chamber is thus defined wherein a die 33 of semiconductor material is arranged and whereon an electronic circuit is conventionally integrated, not shown in the figure.

This die 33 of semiconductor material is separated from said printed circuit board 31 by an insulating layer 34 or a series of suitably overlapped layers.

Advantageously, according to the invention this separation is realised by a method comprising the steps of:
- depositing on the board 31 of an insulating layer 34 in the strip form, realised for example with a polyammide layer;
- definition of passage opening in said insulating layer 34, in correspondence with conducting ends or tracks of said board, so as to form openings 35 for contact vias 39 for the electrical connection between ends of the die 33 and corresponding ends of the board 31;
- alignment of the opening 35 with end pads 38 in connection for instance with the gate, source and drain regions of the electronic devices integrated on the silicon die 33;
- application on the insulating layer 34 of a routing layer of conductor material, for example copper, for forming said contact vias 39;
- arrangement of small welding balls 37 in correspondence with said end pads 38 or of said contact vias 39;
- welding of the die 33, prone placed and leaning on the insulating layer 34 so that the end pads 38 are centred on the openings 35;
- welding of said protection element 32 on the rear of the die 33 to cover the component and by means of further small welding balls 37;
- further welding of the edges of said protection element 32 with coupling of the same with a further end arranged all around the edge of the electronic component 30 for allowing an electric contact with the rest of the die 33;
- separation of the thus obtained component 30, for example by cutting, for the use thereof.

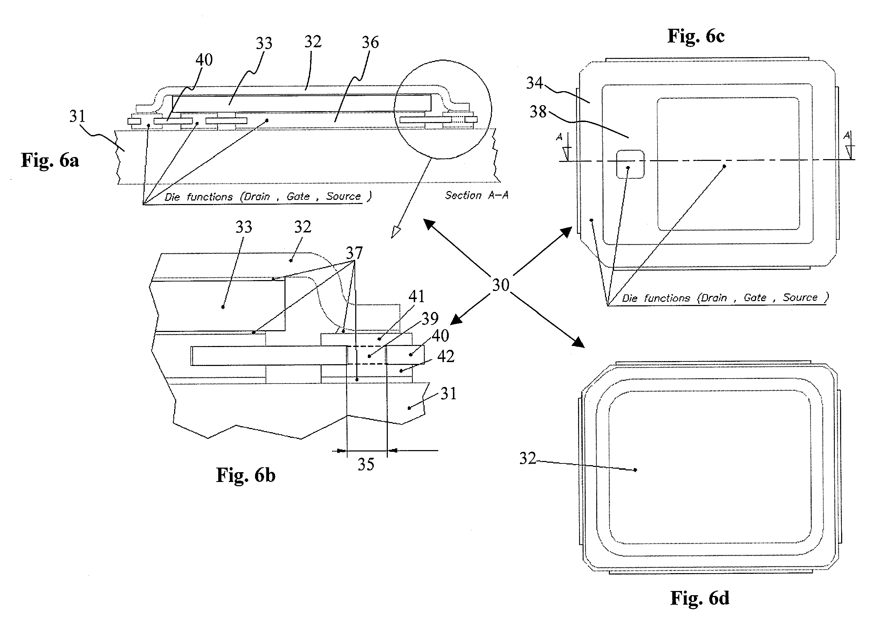

Figures 6a, 6b show instead a section view and an enlarged detail of the same unleaded electronic component 30 of figures 5a and 5b, mounted on a printed circuit board 31 according to an approach defined "thick".

Figures 6c and 6d show two respectively top and bottom views of said component.

In the set of figures 6a, 6b, 6c and 6d the same numbers will be used as those used in the set of figures 5a, 5b, 5c and 5d for the components being present in both the sets of figures.

The component 30 comprises a protection lid element 32 of conductor material, for example copper, substantially tray-like shaped and associated with the board 31 in a reverse tray-like configuration with peripheral edges which lean on the board and maintain the tray plane parallel to the board 31 and in prefixed spaced relation.

A flat chamber is thus defined wherein a die 33 of semiconductor material is placed whereon an electronic circuit is conventionally integrated, not shown in the figure.

This die 33 of semiconductor material is separated from said printed circuit board 31 by an insulating layer or panel 40, or even by a series of suitably overlapped panels. This insulating layer 40 is thus extended above the board 31.

Advantageously, according to the invention this separation is realised by a method comprising the steps of:
- deposition of an insulating separator layer 40, comprising for example an alluminium oxide as A1203, between the die 33 of semiconductor material and the printed circuit board 31;
- perforation of said insulating separator layer 40 so as to realise some openings 35 for contact vias 39 for the electrical connection between ends of the die 33 and corresponding ends of the board 31;
- alignment of the openings 35 with end pads 38 in connection for instance with the gate, source and drain regions of the electronic devices integrated on the silicon die 33;
- application on the separator layer 40 of a routing layer of conductor material, for example of copper, for forming said contact vias 39;
- formation of internal copper pads 41;
- arranging small welding balls 37 in correspondence with said end pads 38 of the die;
- prone arrangement of said die 33 with the pads 38 facing said contact vias 39 so that the end pads 38 are substantially aligned with said internal pads 41;
- welding of said reversed tray-like shaped protection and covering element 32 with a flat plane tied to the rear of the die 33 and peripheral edges fixed to the board 31.

In conclusion, the method according to the invention ensures accurate coplanarity and arrangement of the contact centres of an electronic component; the lack of coplanarity between the copper pads can be limited up to a thickness of some microns.

The layer interposed between the silicon of the die of semiconductor material and the printed circuit board PCB helps to reduce the mechanical stress on the same die of semiconductor material increasing the distance between the two surfaces.

A double welding layer protects the die of semiconductor material and ensures a minimal mechanical stress thereon.

The complete welding of the lid frame in copper, with the edge of the electronic component ensures that the same component is tight and protects the die of semiconductor material, which is sensitive to damages due to the environmental conditions, avoiding the expensive underfilling operations; moreover, the electronic component tight with lid frame in copper, is much more reliable than the standard electronic components.

Another advantage of the mounting method of electronic components of the present invention is given by a reduced number of steps, with respect to the mounting methods used up to now.

## Claims

1. Mounting method of power and/or signal electronic components (30) to be assembled on printed circuit boards PCB (31) equipped with conducting tracks (36) or ends, wherein each component comprises a die (33) of semiconductor material whereon an integrated circuit has been realised with pads (38) or electric contact ends; **characterised in that** it provides:
- the deposition, on the board (31), of an insulating layer (34);
- the definition of passage openings (35) in said insulating layer (34) in correspondence with predetermined conducting tracks (36) or ends of said board;
- application, on the insulating layer (34), of a conducting and routing layer for forming contact vias (39) through said openings (35);
- providing welding small balls (37) in correspondence with said end pads (38) of the die;
- prone arrangement of said die (33) with the pads (38) facing said contact vias and leaning on the insulating layer (34) so that the end pads (38) are substantially aligned with said openings (35);
- welding, on a reversed tray-like shaped protection and covering element (32) with a flat part tied to the rear of the die (33) and peripheral edges fixed to the board (31).

2. Method according to claim 1, **characterised in that** said insulating layer (34) is deposited in the strip-like form.

3. Method according to claim 1, **characterised in that** said insulating strip is a polyammide layer.

4. Method according to claim 1, **characterised in that** said small welding balls (37) are optionally arranged above said contact vias.

5. Method according to claim 1, **characterised in that** said end pads (38) correspond to connections of the gate, source and drain regions of the electronic devices integrated on the die (33).

6. Method according to claim 1, **characterised in that** it provides an insulating separator layer (40) between the die of semiconductor material (33) and the printed circuit board (31).

7. Protective casing for a power and/or signal electronic component (30) to be assembled on printed circuit boards PCB (31) equipped with conducting tracks (36) or ends, wherein each component comprises a die (33) of semiconductor material whereon a circuit has been realised integrated with electric contact pads (38) or ends; **characterised in that** it comprises a insulating layer (34) interposed between the die (33) and said board (31) wherein predetermined passage openings have been provided for contact vias (39) between said pads (38) and corresponding conducting tracks (36) or ends; a reversed tray-like shaped protection element (32) being provided to cover the die (33) with a flat part tied to the rear of the die (33) and peripheral edges fixed to the board (31).
